Europäisches Patentamt

European Patent Office

Office européen des brevets

(19)

(11)  **EP 0 996 231 B1**

(12)     **EUROPÄISCHE PATENTSCHRIFT**

(45) Veröffentlichungstag und Bekanntmachung des Hinweises auf die Patenterteilung:
**13.06.2001  Patentblatt 2001/24**

(51) Int Cl.⁷: **H03M 13/00**

(21) Anmeldenummer: **98119880.7**

(22) Anmeldetag: **20.10.1998**

(54) **Verfahren und Anordnung zum Erzeugen von fehlergesicherten Datenblöcken durch Erzeugen von Paritätsworten und Datenträger mit gemäss dem Verfahren erzeugten Datenblöcken**

Method and device for generating error protected data blocks by generating parity words as well as data carrier including data blocks generated according to the method

Méthode et dispositif pour générer des blocs de données protégées contre des erreurs ainsi que support de données comprenant des blocs de données générées selon la méthode

(84) Benannte Vertragsstaaten:
**AT BE CH CY DE DK ES FI FR GB GR IE IT LI LU MC NL PT SE**
Benannte Erstreckungsstaaten:
**AL LT LV MK RO SI**

(43) Veröffentlichungstag der Anmeldung:
**26.04.2000  Patentblatt 2000/17**

(73) Patentinhaber: **DIG Microcode GmbH**
**52076 Aachen (DE)**

(72) Erfinder: **Seehausen, Gerhard, Prof. Dr.**
**52076 Aachen (DE)**

(74) Vertreter: **Klunker . Schmitt-Nilson . Hirsch**
**Winzererstrasse 106**
**80797 München (DE)**

(56) Entgegenhaltungen:
EP-A- 0 584 864      DE-A- 3 119 669
DE-A- 3 702 697      US-A- 5 040 179
US-A- 5 140 596      US-A- 5 285 455

• LIU: "architecture for VLSI design of Reed-Solomon encoders" IEEE TRANSACTIONS ON COMPUTERS, Bd. c-31, Nr. 2, Februar 1982, Seiten 170-175, XP002096067

**Beschreibung**

Die Erfindung betrifft ein Verfahren zum Erzeugen von fehlergesicherten Datenblöcken durch Erzeugen von Paritätsworten.

Das Erzeugen von fehlergesicherten Datenblöcken durch Erzeugen von Paritätsworten, die den einzelnen zu sichernden Informationsworten, hier als Eingangsdatenblöcke bezeichnet, hinzugefügt werden, ist auf verschiedenen Gebieten der Informationsverarbeitung bekannt. Im vorliegenden Fall geht es in erster Linie um die Fehlersicherung bei digitalen Speichersystemen.

Im Vordergrund steht hierbei das Compact Disc System. Ausgangspunkt ist die Fehlersicherung von digitalen Nutzdaten [X], die zu einem Datenblock [Y], auch Rahmen genannt, zusammengefaßt und durch Paritätsdaten oder Paritätsworte ergänzt werden. Aus der so entstehenden Redundanz besteht die Möglichkeit der Fehlererkennung und der Fehlerkorrektur. Die Anzahl der korrigierbaren und erkennbaren Fehler wird durch die sogenannte minimale Hammingdistanz $d_{min}$ festgelegt, wobei

$$k = d_{min} - 1$$

Fehler erkennbar und

$$e = Int[k/2]; \ Int[X] = \text{größte ganze Zahl} \leq X$$

Fehler korrigierbar sind. Beim Compact-Disc-System ist zum Beispiel e=2 und k=4. In der DE 31 19 669 wird ein systematischer Code vorgeschlagen, wobei systematisch bedeutet, daß die Eingangsinformationssymbole unkodiert im Ausgangsblock enthalten sind. Dieser Code basiert auf dem Galois-Feld oder Galois-Körper (GF($2^K$)), wobei der Grad K die Bitanzahl der zu kodierenden Worte und die maximale Blocklänge, d.h.: die maximale Anzahl der Worte in einem Block, zu m=$2^K$-1 festlegt. Bei 8-Bit-Datenworten ist zum Beispiel K=8 und die maximale Blocklänge m = $2^K$-1= 255. Jedes GF($2^K$) wird durch ein "primitives" Polynom Q(q) festgelegt, wobei die Elemente des GF($2^K$) durch Potenzieren $\alpha^i = \alpha_i = \alpha(q) = q^i \rfloor_{mod Q(q)}$ definiert sind. Die Polynome Q(q) und die Elemente $\alpha^i$ für jedes GF($2^K$) sind bekannt. Koeffizienten von Q(q) sind Elemente aus GF(2). Q(q) ist ein irreduzibles Polynom über GF(2), das heißt es kann nicht in ein Produkt aus Polynomen kleineren Grades mit den Koeffizienten aus GF(2) aufgespalten werden. Für jedes GF($2^K$) sind eindeutige Rechenregeln festgelegt. Man kann die Elemente des GF($2^K$) tabellarisch darstellen. Zum Beispiel ergibt sich für GF($2^K$) mit Q(q) = $q^3 + q + 1$ :

## Tabelle 1

| $q^i$ | | | | Kurzform |
|---|---|---|---|---|
| $q^0$ | | | $q^0$ | 001 |
| $q^1$ | | $q^1$ | | 010 |
| $q^2$ | $q^2$ | | | 100 |
| $q^3$ | | $q^1 +$ | $q^0$ | 011 |
| $q^4$ | $q^2 +$ | $q^1$ | | 110 |
| $q^5$ | $q^2 +$ | $q^1 +$ | $q^0$ | 111 |
| $q^6$ | $q^2$ | $+$ | $q^0$ | 101 |
| $q^7$ | | | $q^0$ | 001 |
| $q^8$ | | $q^1$ | | 010 |
| | | $\cdot$ | | $\cdot$ |
| | | $\cdot$ | | $\cdot$ |

Zur Erläuterung der Rechenregeln sei vorausgesetzt, daß die beiden Elemente, oder Worte, [A] und [B] dem $GF(2^K)$ entstammen, wobei

$$[A] = [a_{k-1}, ..., a_0] \, a_0] \qquad [A], [B] \in GF(2^K)$$

$$[B] = [b_{k-1}, ..., b_0] \qquad a_i, b_i \in GF(2)$$

in vorstehender Form definiert sind. Gemäß der Additionsregel im $GF(2^K)$ wird die Addition von [A], [B] komponentenweise mod. 2 durchgeführt, so daß sich als Ergebnis

$$[C] = [A] + [B]$$

$$[C] = [a_{k-1} + b_{k-1}, ..., a_0 + b_0]$$

ergibt. Für die Multiplikation wird die Polynomschreibweise von [A] und [B] gemäß

$$A(q) = a_{k-1}q^{k-1} + ... + a_1 q + a_0$$

$$B(q) = b_{k-1}q^{k-1} + ... + b_1 q + b_0$$

verwendet, wobei die Potenz von q die Lage einer Bitstelle innerhalb des Elementes [A] kennzeichnet. Die Multiplikation im $GF(2^K)$ wird als Polynom-Multiplikation modulo des erzeugenden "primitiven" Polynom Q(q) gemäß

$$C(q) = A(q) \cdot B(q) \Big|_{\text{mod. } Q(q)}$$

durchgeführt.

Zur Erzeugung des Codeblocks [Y] wird gemäß der DE 31 19 669 die Prüfmatrix in der Form

$$[H] = \begin{bmatrix} 1 \alpha^b & \alpha^{2b} & \alpha^{3b} & .... & \alpha^{(m-2)b} & \alpha^{(m-1)b} \\ 1 \alpha^{(b-1)} & \alpha^{2(b-1)} & \alpha^{3(b-1)} & .... & \alpha^{(m-2)(b+1)} & \alpha^{(n-1)(b+1)} \\ 1 \alpha^{(b+2)} & \alpha^{2(b+2)} & \alpha^{3(b+2)} & .... & \alpha^{(m-2)(b+2)} & \alpha^{(m-1)(b+2)} \\ ... \\ 1 \alpha^{(b+2e-1)} & \alpha^{(b+2e-1)2} & \alpha^{(b+2e-1)3} & .... & \alpha^{(b+2e-1)(m-2)} & \alpha^{(b+k-1)(m-1)} \end{bmatrix}$$

mit b = 0 verwendet. Alternativ wird eine Form vorgeschlagen, die aus der Umformung von [H] durch Multiplikation jeder Zeile i mit einem Koeffizienten $\alpha^i$ hervorgeht, wobei i fortlaufend von oben nach unten von i=0 bis i=2e -1 anwächst. In der DE'669 wird die genannte Prüfmatrix [H] vorgeschlagen, indem die Eingangsdatenworte [X] und die zu ermittelnden Paritätsworte [P] zu [Y] = [X, P] zusammengefaßt, mit [H] multipliziert und im Ergebnis zu Null gesetzt werden.

$$[Y] \cdot [H] = 0$$

Aus dieser Operation entstehen 2e Gleichungen, aus denen die unbekannten 2e Paritätsworte [P] bestimmt werden können. In der DE'699 ist keine mögliche Schaltung zum Lösen des Gleichungssystems angegeben. Man kann nun daran denken, für jedes Paritätswort eine Reihe von Multiplikationen vorzunehmen. Das Erzeugen der Paritätsworte [P] gestaltet sich bei diesem Verfahren aufwendig und schaltungsintensiv. Die Schaltungsarchitektur ist bei hohen Datenraten und der Forderung nach Echtzeitfähigkeit sehr kostenintensiv, da sie den Gegebenheiten des Galois-Feldes und den darauf basierenden Rechenregeln angepaßt werden muß.

Das folgende Beispiel soll die Vorgehensweise nach der oben angegebenen Möglichkeit noch einmal verdeutlichen. In diesem Beispiel wird $K = 3$, $2e = 2$, $m = 2^K -1 = 7$ und $b=0$ angenommen. Der Eingangs-informationsblock sei $[Y] = [X_5, X_4, X_3, X_2, X_1]$ und der Ausgangsdatenblock sei $[Y] = [X_5, X_4, X_3, X_2, X_1, P_2, P_1]$. Für dieses Beispiel berechnen sich aus $[Y] \cdot [H]$ 0 die Paritätsworte $P_2$, $P_1$ folgendermaßen:

$$P_2 = \alpha^6 \cdot X_5 + \alpha \cdot X_4 + \alpha^2 \cdot X_3 + \alpha^5 \cdot X_2 + \alpha^3 \cdot X_1 \tag{1}$$

$$P_1 = \alpha^2 \cdot X_5 + \alpha^3 \cdot X_4 + \alpha^6 \cdot X_3 + \alpha^4 \cdot X_2 + \alpha \cdot X_1 \tag{2}$$

Es sind nach diesem Verfahren $2e \cdot (m-2e) = 10$ Multiplikationen pro Rahmen im $GF(2^K)$ bzw. bei Einsatz tabellarischer Multiplikation, die schaltungstechnisch einfacher und schneller zu realisieren ist, 10 ROM-basierte Multiplikationstabellen zur Ermittlung von [P] erforderlich.

Für die Anwendung im Compact-Disc-System sind beispielsweise $K = 8$, $e = 2$, $m = 32$ und $b = 0$ zu setzen. Folglich ergeben sich $2e \cdot (m-2e) = 4 \cdot 28 = 112$ Multiplikationen pro Rahmen, was bei tabellarischer Multiplikation 112 Tabellen erfordert. Da dieser Aufwand zu groß ist, wird bei der Compact Disc auf die schnelle parallele Umsetzung verzichtet und in serieller Weise unter Einsatz eines komplexen rechnerbasierten Steuermechanismus verfahren. Die serielle Ausführung birgt allerdings den Nachteil, daß nur vergleichsweise niedrige Datenraten verarbeitet werden können.

Aus "Architecture for VLSI Design of Reed Solomon Encoders", Kuang J. Liu, IEEE Transactions on Computers Vol. C31, (1982) Febr., No. 2, USA, ist bekannt, mit einem Kodeerzeuger Paritätswörter für Informations-Datenblöcke mittels Polynom-Division durch das Generator-Polynom mit anschließender Restbestimmung zu erzeugen.

Der Erfindung liegt die Aufgabe zugrunde, eine schaltungstechnisch einfacher zu realisierende Kodierung bzw. Berechnung der Paritätsworte zu ermöglichen, wodurch sich ein geringer Aufwand bei gleichzeitig höherem Datendurchsatz einstellt.

Gelöst wird die Aufgabe durch ein Verfahren mit den Merkmalen des Anspruchs 1.

Die Erfindung beruht auf der Ausnutzung des Umstands, daß die Blöcke [Y] zyklisch sind. Das heißt, daß ein neuer gültiger Block $[Y]_i$ entsteht durch zyklische Verschiebung der Elemente eines beliebigen gültigen Blockes $[Y]_i$:

$$[Y]_j = [X_{5j}, X_{4j}, X_{3j}, X_{2j}, X_{1j}, P_{2j}, P_{1j}]$$

$$[Y]_i = [X_{4j}, X_{3j}, X_{2j}, X_{1j}, P_{2j}, P_{1j}, X_{5j}]$$

Folglich kann die Kodeerzeugung auf einfachere Weise mittels eines Generator-Polynoms G(z) vorgenommen werden, das auf 2e Nullstellen aus $GF(2^K)$ basiert:

$$G(z) = (z-\alpha^b)(z-\alpha^{b+1}) \ldots \quad (z-\alpha^{b+2e-1})$$

Die zyklische Eigenschaft des durch G(z) erzeugten Kodes kann unter anderem durch die Eigenschaft $z^m + 1 \mid_{\text{mod } G(z)} = 0$ nachgewiesen werden.

Es ist üblich, den Informations-Datenblock $[X] = [X_n X_{n-1} \ldots X_2 X_1]$ durch ein Polynom darzustellen

$$X(z) = X_n \cdot z^{n-1} + X_{n-2} \cdot z^{n-2} + \ldots + X_2 z + X_1$$

wobei die Potenz von z die Lage des Informationswortes innerhalb des Datenblocks angibt. Zur Erzeugung des Ausgangs-Datenblocks

$$[X] = [X_0\ X_{n-1}\ ...\ X_2\ X_1\ P_{2e}\ P_{2e-1}\ ....\ P_2\ P_1],$$

also zur Generierung der Paritätsworte $P_i$ wird der Informations-Datenblock $[X]$ um die Anzahl $2e$ der Paritätsworte so erweitert, daß die $X_i$ zur Platzfreigabe um die Anzahl der Paritätsworte nach links verschoben werden. In der Polynom-Darstellung entspricht dieses der Multiplikation mit $z^{2e}$, so daß sich die folgende Form einstellt:

$$z^{2e} \cdot X(z) = X_n\ z^{2e+n-1} + X_{n-1}Z^{2e+n-2} + ... + X_2 z^{2e-1} + X_1 z^{2e}$$

Es können nun die Paritätsworte $P_i$ mittels Polynom-Division durch das Generator-Polynom $G(z)$ und anschließender Restbestimmung ermittelt werden. Die Paritätsworte $P_i$ ergeben sich dann ebenfalls in der folgenden Polynom-Darstellung:

$$P(z) = P_{2e}Z^{2e-1} + P_{2e-1}z^{2e-2} + ... + P_2 z + P_1$$

$$= z^{2e}X(z)\ \big|_{modG(z)} = \text{Rest}\ [z^{2e}X(z) : G(Z)].$$

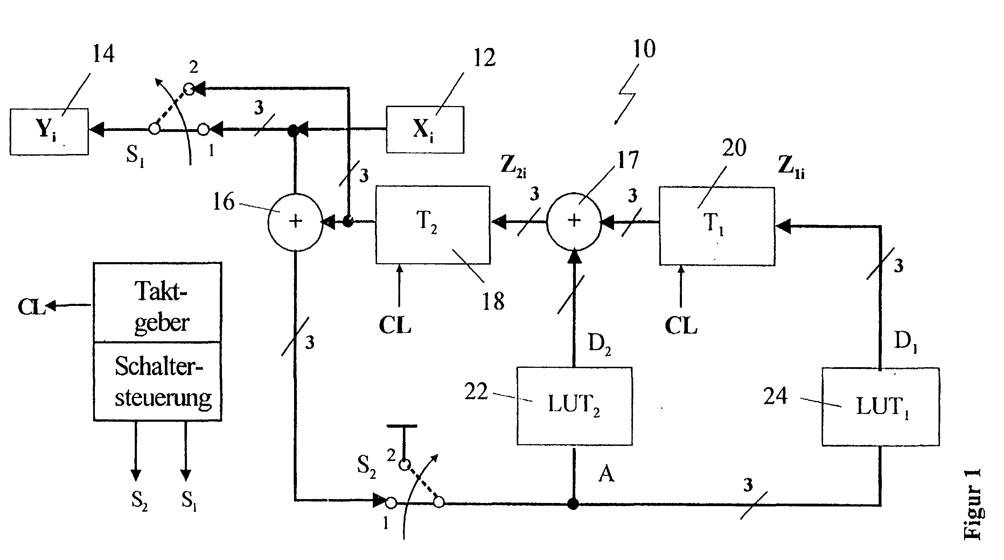

Diese Polynom-Division ist schaltungstechnisch verhältnismäßig einfach durchzuführen, wie in Figur 1 gezeigt ist.

Das Verfahren soll anhand eines Beispiels erläutert werden. Für das Beispiel sei $K = 3$, $2e = 2$, $m = 2^K-1 = 7$ und $b = 0$ angenommen. Der zu kodierende Eingangs-Informationsblock sei $[X] = [\alpha^2\ 0\ \alpha^5\ 0\ \alpha]$. Das zugehörige Informations-Polynom ist dann $X(z) = \alpha^2 z^4 + \alpha^5 z^2 + \alpha$. Als Generator-Polynom ergibt sich

$$G(z) = (z-\alpha^b)(z-\alpha^{b+1}) = (z-1)(z-\alpha) = (z+1)(z+\alpha)$$

$$= z^2 + (\alpha+1)z+\alpha = z^2+\alpha^3 z+\alpha$$

Die Ermittlung der Paritätsworte durch Polynom-Division und Restbestimmung liefert dann

$$P(z) = z^{2e}X(z)\big|_{mod\ G(Z)}$$

$$= \text{Rest}\ [z^2(\alpha^2 z^4 + \alpha^5 z^2 + \alpha) : (z^2 + \alpha^3 z + \alpha)]$$

$$= \alpha^6 z + \alpha^2 \qquad\qquad\qquad (3)$$

Folglich ergeben sich die gesuchten Paritätsworte als Koeffizienten von $P(z)$ zu $P_2 = \alpha^6$, $P_1 = \alpha^2$ und der gesuchte Ausgangsblock ist dann

$$[Y] = [X_5\ X_4\ X_3\ X_2\ X_1,\ P_2\ P_1] = [\alpha^2 0\ \alpha^5 0\ \alpha,\ \alpha^6\ \alpha^2]$$

Die Lösung des aus der Prüfmatrix $[H]$ entstehenden Gleichungssystems (1) und (2) führt zu dem gleichen Ergebnis, allerdings nach einem anderen, schaltungsmäßig aufwendigeren Verfahren:

$$P_2 = \alpha^6 \cdot \alpha^2 + \alpha \cdot 0 + \alpha^2 \textstyle\sum \alpha^5 + \alpha^5 \cdot 0 + \alpha^3 \cdot \alpha = \alpha^6$$

$$P_1 = \alpha^2 \cdot \alpha^2 + \alpha^3 \cdot 0 + \alpha^6 \cdot \alpha^5 + \alpha^4 \cdot 0 + \alpha \cdot \alpha = \alpha^2$$

Bei einem sogenannten verkürzten Kode, wie er bei der Compact Disc Verwendung findet, wird nicht die maximal mögliche Anzahl $m = 2^K-1$, sondern eine geringere Anzahl $m_v$ zu einem Block zusammengefaßt. Daß das erfindungsgemäße Verfahren auch auf verkürzte Kodes anzuwenden ist, soll das nachfolgende Beispiel zeigen. Hier wird K = 3, 2e = 2, m(max) = $2^K$-1=7, m, (verkürzt) = 5 und b = 0 gewählt.

Als Eingangs-Informationsdatenblock sei

$$[X] = [X_3 X_2 X_1] = [\alpha^4, \alpha, \alpha^6]$$

angenommen. Der Ausgangsblock ergibt sich dann in der Form

$$[Y] = [X_3 X_2 X_1, P_2 \, P_1].$$

Das zu [X] gehörende Informations-Polynom lautet dann

$$X(z) = \alpha^4 z^2 + \alpha z + \alpha^6.$$

Wird wieder das Generator-Polynom

$$G(z) = (z-\alpha^b)(z-\alpha^{b+1}) = z^2 + \alpha^3 z + \alpha$$

verwendet, so erhält man das Paritätspolynom

$$P(z) = z^{2e} X(z) \big|_{modG(Z)} =$$

$$= \text{Rest } [z^2(\alpha^4 z^2 + \alpha z + \alpha^6) : (z^2 + \alpha^3 z + \alpha)$$

$$= \alpha^2 z + \alpha^6 \Rightarrow P_2 = \alpha^2, P_1 = \alpha^6$$

Das obige Gleichungssystem (1), (2) liefert:

$$P_2 = \alpha^2 \alpha^4 + \alpha^5 \alpha + \alpha^3 \alpha^6 = \alpha^2$$

$$P_1 = \alpha^6 \alpha^4 + \alpha^4 \alpha + \alpha \alpha^6 = \alpha^6$$

Um die einzelnen Schritte bei der schaltungstechnisch durchgeführten Polynom-Division zu verdeutlichen, soll das oben angegebene Beispiel des Paritätspolynoms gemäß Gleichung (3) im einzelnen ausgeführt werden:

$$(z^6\alpha^2 + z^4\alpha^5 + z^2\alpha):(z^2 + \alpha^3 z + \alpha) = z^4\alpha^2 + z^3\alpha^5 + z^2\alpha^4 + z\alpha^2 + \alpha$$

$$z^6\alpha^2 + z^5\alpha^5 + z^4\alpha^3$$

$$= z^5\alpha^5 + z^4(\alpha^5 + \alpha^3) + z^2\alpha \qquad \Big/ \quad \alpha^5 + \alpha^3$$

$$= z^5\alpha^5 + z^4\alpha^2 + z^2\alpha \qquad \qquad = \alpha^2$$

$$z^5\alpha^5 + z^4\alpha + z^3\alpha^6$$

$$= z^4(\alpha^2 + \alpha) + z^3\alpha^6 + z^2\alpha$$

$$= z^4\alpha^4 + z^3\alpha^6 + z^2\alpha$$

$$z^4\alpha^4 + z^3\alpha^7 + z^2\alpha^5$$

$$= z^3(\alpha^7 + \alpha^6) + z^2(\alpha^5 + \alpha) = \qquad \Big/ \quad \alpha^5 + \alpha = \alpha^6$$

$$= z^3\alpha^2 + z^2\alpha^6$$

$$z^3\alpha^2 + z^2\alpha^5 + z\alpha^3$$

$$z^2(\alpha^5 + \alpha^6) + z\alpha^3$$

$$= z^2\alpha + z\alpha^3$$

$$z^2\alpha + z\alpha^4 + \alpha^2$$

$$= z(\alpha^4 + \alpha^3) + \alpha^2 \qquad \qquad \Big/ \quad \alpha^4 + \alpha^3 = \alpha^6$$

$$= z\alpha^6 + \alpha^2$$

Wie bereits erwähnt, ist zur Erzeugung der Paritätsworte hier lediglich der Polynomrest von Interesse, das Ergebnis der Division, also der rechts oben stehende Quotient ist nur insofern wichtig, als die einzelnen Koeffizienten $\alpha^2$, $\alpha^5$, ... für die Multiplikation mit den einzelnen Termen des Generatorpolynoms verwendet werden. Man erkennt, daß das bei der Multiplikation des jeweiligen Zwischenergebnisses mit den einzelnen Termen des Generatorpolynoms gewonnene Ergebnis nicht berücksichtigt zu werden braucht, da es bei der nachfolgenden im $GF(2^K)$ definierten Addition (entspricht der Subtraktion) wegfällt.

Für das hier betrachtete Beispiel sind also lediglich der Term $\alpha^3 z$ und $\alpha$ des Generatorpolynoms wichtig.

Figur 1 zeigt ein Blockschaltbild einer Schaltung zum Dividieren zweier Polynome, um zwei Paritätsworte zu erzeugen,

Figur 2 zeigt ein schematisches Schaltungsdiagramm, welches eine Ver-allgemeinerung der in Figur 1 gezeigten Schaltung auf beliebige Werte von 2e darstellt,

Figur 3 zeigt ein schematisches Schaltungsdiagramm einer weiteren Schaltung zum Erzeugen von Paritätswörtern;

Figur 4 zeigt ein Schaltungsdiagramm einer weiteren Schaltung zum Erzeugen von Paritätswörtern;

Figur 5 zeigt ein Schaltungsdiagramm einer Schaltung zum Erzeugen von zwei Paritätswörtern als Spezialfall der Schaltung gemäß Figur 4;

Figur 6 zeigt ein schematisches Schaltungsdiagramm einer Ausführungsform einer Schaltung zum Erzeugen von 2e Paritätswörtern;

Figur 7 zeigt die Schaltung nach Figur 6 für den Spezialfall der Erzeugung von zwei Paritätswörtern, und

Figur 8 zeigt ein Ersatzschaltbild für die in Figur 3 gezeigte Schaltung, wenn diese sowohl für Multiplikationen als auch für Divisionen verwendet wird.

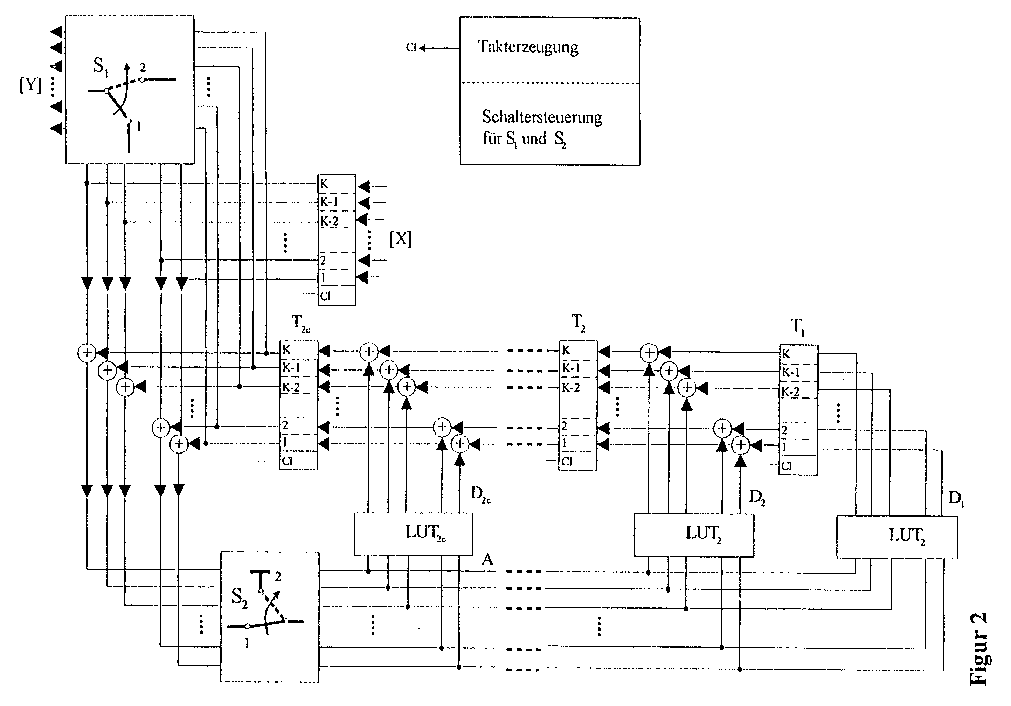

Zunächst sei Figur 1 betrachtet, aus deren Erläuterung sich dann auch das Verständnis der Schaltung nach Figur 2 von allein ergibt.

Die schaltungstechnische Realisierung der Polynom-Division gemäß der Rechenregeln im GF($2^K$) soll anhand von Figur 1, in der alle Signalverbindungen aus Bündeln von K-Leitungen bestehen, erläutert werden.

$S_2$, $S_1$ sind Schalter für K-Signalleitungen mit den Schalterstellungen 1 und 2.

$T_i$: Ein-Takt-Verzögerung für K Signalleitungen.

Der Eingangsdatenblock [X] sei vollständig oder elementenweise in einem Register 12 enthalten, an dessen Ausgang jeweils ein Wert $X_i$ ansteht.

Da bei dem hier betrachteten Beispiel K=3, sind sämtliche Signalleitungen dreiadrig ausgeführt, eine Ader für jeweils ein Bit. Entsprechendes gilt auch für die übrigen Elemente der in Figur 1 gezeigten Schaltung.

Wie oben gezeigt, bestehen die fünf ersten Elemente des fehlergesicherten Datenblocks [Y] aus den Elementen des Eingangsdatenblocks [X]. Dem gesicherten Datenblock [Y] sollen jetzt zwei Paritätswörter hinzugefügt werden. Während der schrittweise vorgenommenen Polynomdivision zur Erzeugung der Paritätswörter werden bei jedem Divisionsschritt die einzelnen Werte $X_i$ über einen in der Stellung "1" befindlichen Schalter $S_1$ auf den Ausgang gegeben, von dem die fehlergesicherten Datenwörter abgenommen werden, hier dargestellt beispielhaft als Register 14.

Die Schaltung nach Figur 1 enthält Verzögerungsglieder 18 und 20, hier zusätzlich mit $T_2$ bzw. $T_1$ bezeichnet, entsprechend 2e=2. Für die Verzögerungsglieder können bekannte digitale D-Flipflops mit Taktsteuerung verwendet werden, die zum Beispiel die Zustandsfolgetabelle $Q^+$=f (Cl, D)

Tabelle 2

| D | CL | Q | Q+ |
|---|----|---|----|
| 0 | 0 | 0 | 0 |
| 0 | 0 | 1 | 1 |
| 0 | 1 | 0 | 0 |
| 0 | 1 | 1 | 0 |
| 1 | 0 | 0 | 0 |
| 1 | 0 | 1 | 1 |
| 1 | 1 | 0 | 1 |
| 1 | 1 | 1 | 1 |

aufweisen.

An den Ausgängen der beiden Verzögerungsglieder 18 und 20 befindet sich jeweils ein Element für die Modulo 2-Addition in Form eines Exklusiv-Oder-Glieds 16 bzw. 17 (es sei noch einmal angemerkt, daß entsprechend K=3 das Exklusiv-Oder-Glied 16 ebenso wie das Glied 17 tatsächlich aus drei Elementen gebildet ist).

Die Modulo 2-Addition ($\oplus$) durch die Exklusiv-Oder-Glieder entspricht folgender Wahrheitstabelle (Tabelle 3):

Tabelle 3

| X1 | X2 | Y |
|----|----|---|
| 0 | 0 | 0 |
| 0 | 1 | 1 |
| 1 | 0 | 1 |
| 1 | 1 | 0 |

Die Schaltung nach Figur 1 enthält außerdem zwei Tabellenspeicher 22 und 24, hier zusätzlich bezeichnet mit LUT$_2$ bzw. LUT$_1$, abgeleitet von dem Begriff Look-Up-Table. Die Anzahl der Speicherplätze in diesen Tabellenspeichern beträgt 8 ($2^K$). Diese Tabellenspeicher können entweder durch handelsübliche elektronische Read-Only-Memory-Bausteine oder durch programmierbare Logikzellen (PLD) realisiert werden. An die Adresseneingänge werden Adressen $A_i$ (bei dem jeweiligen Takt) gelegt, und abhängig von der angelegten Adresse wird ein unter dieser Adresse gespeichertes Datenwort $D_i$ ausgelesen. Betrachtet man die Polynom-Division, so enthält jeder Tabellenspeicher für alle in Frage kommenden Werte 0,1, $\alpha$, $\alpha^2$ .... das Produktergebnis, welches durch Multiplizieren des Eingangswerts mit dem betreffenden Koeffizienten des Generator-Polynoms entsteht. Im vorliegenden Fall werden also die möglichen Eingangswerte für den Datenwert $D_2$ mit $\alpha^3$ multipliziert, für den Datenwert $D_1$ mit $\alpha$.

Allgemein gesprochen:

Die LUT$_1$ stellen die Multiplikation der höchsten Stelle des bei der Polynom-Division entstehenden Zwischenergebnisse mit den jeweiligen Koeffizienten des Generator-Polynoms

$$G(z) = z^{2e} + g_{2e}z^{2e-1} + \dots + g_2 z + g_1$$

her.

Die $\text{LUT}_i$ sind gemäß folgender Gleichung zu programmieren

$$D_1 = A \cdot g_1, \, i = 1. \dots 2e,$$

wobei die Koeffizienten $D_1$, $g_1$, A Elemente aus $GF(2^K)$ sind und die Multiplikation im $GF(2^K)$ auszuführen ist. Dieser Vorgang ist einmalig bei der Programmierung durchzuführen.

Für das vorliegende Beispiel ($G(z) = z^2 + \alpha^3 z + \alpha$) sind die Tabellenspeicher mit folgendem Inhalt programmiert:

Tabelle 4

| Adresse A | Daten $D_2$ |
|---|---|
| 0 | 0 |
| $\alpha$ | $\alpha^4$ |
| $\alpha^2$ | $\alpha^5$ |
| $\alpha^3$ | $\alpha^6$ |
| $\alpha^4$ | 1 |
| $\alpha^5$ | $\alpha$ |
| $\alpha^6$ | $\alpha^2$ |
| 1 | $\alpha^3$ |

Tabelle 5

| Adresse A | Daten $D_1$ |
|---|---|
| 0 | 0 |
| $\alpha$ | $\alpha^2$ |
| $\alpha^2$ | $\alpha^3$ |
| $\alpha^3$ | $\alpha^4$ |
| $\alpha^4$ | $\alpha^5$ |
| $\alpha^5$ | $\alpha^6$ |
| $\alpha^6$ | 1 |
| 1 | $\alpha$ |

Zur Aufstellung der LUT-Tabellen sind die $\alpha^i$ als K-Bit-Worte aus dem $GF(2^K)$ (s. Tabelle 1) zu entnehmen.

Der Ablauf der Polynom-Division und die Restermittlung mit Hilfe der in Figur 1 gezeigten Schaltung läuft folgendermaßen ab, wobei noch einmal daran erinnert sei, daß im vorliegenden Beispiel der Eingangsdatenblock (X) $= [\alpha^2 0 \, \alpha^5 0 \, \alpha]$ ist.

Wie bereits erwähnt, sind die beiden Schalter $S_1$ und $S_2$ zunächst in der Stellung "1". Wie ebenfalls schon erwähnt, werden bei jedem Takt Schritte der Polynom-Division durchgeführt, und außerdem werden während der ersten fünf Takte die Elemente von [X] auf den Ausgang für Y gegeben. Im vorliegenden Fall umfaßt der Eingangsdatenblock n=5 Informationsworte mit jeweils k=3 Bits. Wie aus der nachstehenden Tabelle 6 ersichtlich ist, hängen die erhaltenen Zwischenergebnisse von den vorhandenen Daten des gerade aktuellen Takts und den Daten des vorausgehenden Takts ab. Der Takt wird durch einen Taktgeber in Form eines Taktsignals CL erzeugt. Die in Figur 1 gezeigten Verzögerungsglieder 18 und 20 erzeugen jeweils eine Verzögerung um einen Takt, wie aus der obigen Tabelle 2 ersichtlich ist.

Tabelle 6

| Takt | $Y_j$ | $Z_{2j}$ | $Z_{1j}$ | $X_j$ |
|---|---|---|---|---|
| 0 | 0 | 0 | 0 | 0 |
| 1 | $\alpha_2 = (X_5)$ | $\alpha^5$ | $\alpha^3$ | $\alpha^2$ |
| 2 | $0 = (X_4)$ | 1 | $\alpha^6$ | 0 |
| 3 | $\alpha^5 = (X_3)$ | $\alpha^2$ | $\alpha^5$ | $\alpha^5$ |
| 4 | $0 = (X_2)$ | 0 | $\alpha^3$ | 0 |
| 5 = n | $\alpha = (X_1)$ | $\alpha^6$ | $\alpha^2$ | $\alpha$ |
| 6 | $\alpha^6 = (P_2)$ | $\alpha^2$ | 0 | 0 |
| 7 = m | $\alpha^2 = (P_1)$ | 0 | 0 | 0 |

Bei der Aufstellung der Zustandstabelle sind die nachfolgenden Zustandsgleichungen hilfreich:

$$Z_{ij} = \alpha(X_j + Z_{2j-1})$$

$$Z_{2j} = \alpha^3(X_j + Z_{2j-1}) + Z_{1j-1}$$

Die geklammerten Ausdrücke in Tabelle 6 geben die Positionen im Datenrahmen Y an, während sich j auf den Takt bezieht. (Dies gilt auch für die weiteren Tabellen unten.)

Wie aus der obigen Tabelle ersichtlich ist, werden in den ersten fünf Takten die einzelnen Worte des Eingangsdatenblocks in den gesicherten Datenblock (Ausgangsdatenblock) übernommen. Vor dem Takt n+1 werden die Schalter $S_1$ und $S_2$ in die Stellung "2" gebracht. Nun können die zwei Paritätsworte $P_1$ und $P_2$ am Ausgang des Verzögerungsglieds 18 abgenommen und an den Ausgangsdatenblock angefügt werden. Nach dem Takt m=7 ist die Bildung des gesicherten Datenblocks [Y] beendet, und die Schaltung ist für die Bildung der Paritätswörter für den nächsten Eingangsdatenblock bereit, nachdem die Schalter $S_1$ und $S_2$ wieder in die Stellung "1" gebracht worden sind. Das Umschalten der Schalter erfolgt durch eine Schaltersteuerung in Abhängigkeit der als bekannt vorauszusetzenden Anzahl von Worten innerhalb eines Eingangsdatenblocks.

Mit Hilfe der beiden Formeln unter der Tabelle 6 ergibt sich zum Beispiel für $Z_{25}$:

$$Z_{25} = \alpha^3(X_5 + Z_{24}) + Z_{14} = \alpha^3(\alpha + 0) + \alpha^3 = \alpha^4 + \alpha^3 = \alpha^6$$

Figur 2 zeigt eine Schaltung für beliebige Werte von 2e. Zusätzlich zu den Einzelheiten aus Figur 1 sind für die Verzögerungsglieder noch die einzelnen bitweisen Elemente jedes Verzögerungsglieds sowie der zugehörige Takteingang dargestellt. Die Modulo 2-Addierer sind bitweise für jedes einzelne der K-Bits dargestellt. Die Schaltung läßt sich auf eine beliebige Anzahl von Bits erweitern, ebenso läßt sie sich auf einen beliebigen Wert von 2e erweitern.

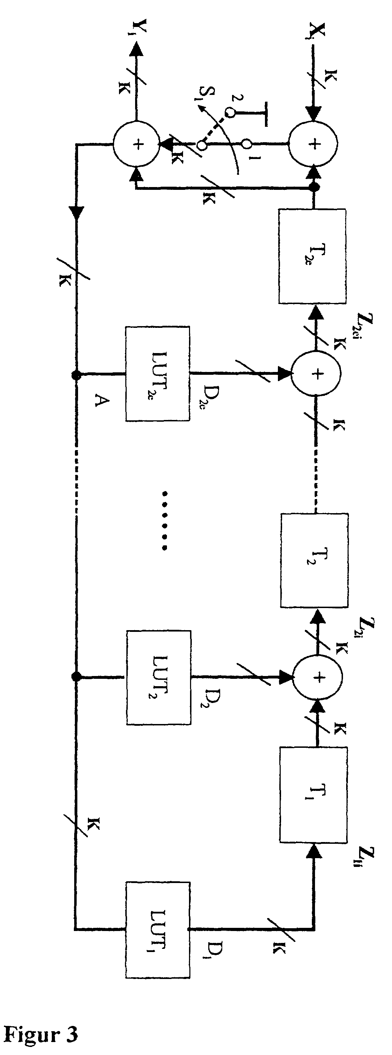

Figur 3 zeigt eine gegenüber der Schaltung nach Figur 2 geringfügig abgewandelte Ausführungsform, wobei jedoch auf die Einzeldarstellungen der einzelnen Bitleitungen verzichtet wurde.

Wie links in Figur 3 zu erkennen ist, kommt diese Schaltung mit nur einem Schalter $S_1$ aus. Zunächst werden die Datenwörter über die beiden EXKLUSIV-ODER-Gatter 17 und 16 in das Register für das Ausgangsdatenwort Y eingetaktet, während der Schalter $S_1$ in der Stellung "1" steht. Die Arbeitsabläufe in der übrigen Schaltung entsprechen dem oben erläuterten Ablauf. Nach Ende des Datenworts wird der Schalter $S_1$ in die Stellung "2" gebracht, so daß die Paritätswörter an das Ausgangsdatenwort Y angefügt werden.

Die in Figur 3 gezeigte Schaltung kann aber auch zum Durchführen eines abgewandelten Verfahrens zur Bildung von Paritätswörtern verwendet werden, wie unten ausgeführt wird.

Eine weitere Möglichkeit der Paritätsbildung besteht darin, nicht wie in der Schaltung nach Figur 1 durchgeführt, den Rest aus der Division des verschobenen Eingangs-Polynoms $z^{m-n} X(z)$ durch das Generator-Polynom $G(z)$ gemäß

$$z^{2e}X(z)\Big|_{\mathrm{mod}G(z)} = \mathrm{Rest}\,[z^{2e}X(z) : G(z)]$$

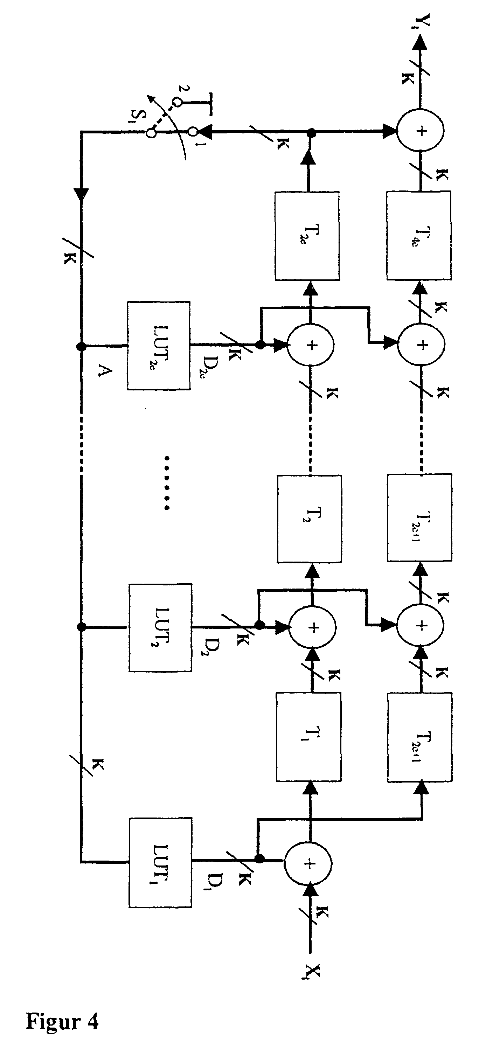

als Paritätsworte zu verwenden, sondern das Ausgangs-Polynom $Y(z)$ durch Multiplikation eines Teilers $C(z)$ mit dem Generatorpolynom $G(z)$ gemäß

$$Y(z) = C(z)G(z)$$

zu gewinnen, wobei der Teiler aus der Division des verschobenen Eingangs-Polynoms $z^{m-n} X(z)$ durch das Generator-Polynom $G(z)$ gemäß

$$C(z) = z^{2e}X(z) : G(z)$$

resultiert. In Figur 4 ist eine Schaltung dargestellt, die zunächst die Ermittlung des Teilers $C(z)$ durch Division und anschließend das Ausgangs-Polynom $Y(z)$ durch Multiplikation erzeugt, wobei die Division in den Verzögerungsgliedern $T_1$ bis $T_{2e}$ und die Multiplikation in den Verzögerungsgliedern $T_{2e+1}$ bis $T_{4e}$ durchgeführt wird. Der Schalter $S_1$ wird unmittelbar nach dem m-ten Takt, bei dem die Division beendet ist, von der Stellung 1 in die Stellung 2 gebracht. Insgesamt sind $m + 2e$ Takte zur Bildung des Ausgangs-Polynoms $Y(z)$ erforderlich.

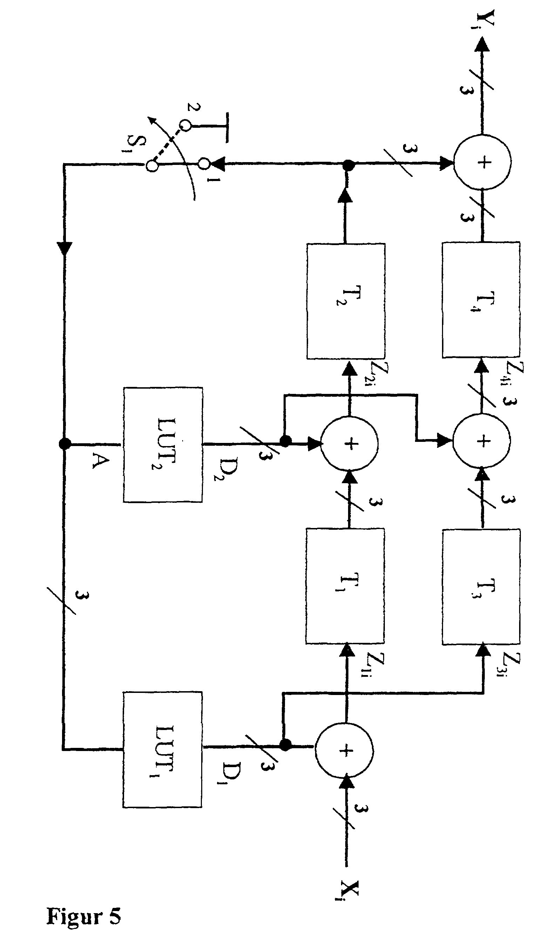

Das Schaltungsbeispiel in Figur 5 zeigt den Aufbau für den Fall, daß $2e=2$ Paritätsworte für einen Informationsblock aus $K = 3$ Bit-Worten unter Verwendung des Generatorpolynoms $G(z) = z^2 + \alpha^3 z + \alpha$ ermittelt werden. Für dieses Beispiel können die LUT-Tabellen 4 und 5 verwendet werden. Für den Eingangs-Informationsblock $[X] = [\alpha^2 0\ \alpha^5 0\ a]$ und das Generatorpolynom $G(z) = z^2 + \alpha^3 z + \alpha$ ergibt sich beispielsweise die folgende taktabhängige Zustandstabelle der Kodierschritte:

| Takt | $Y_j$ | $Z_{4j}$ | $Z_{3j}$ | $Z_{2j}$ | $Z_{1j}$ | $X_j$ |
|---|---|---|---|---|---|---|
| 0 | 0 | 0 | 0 | 0 | 0 | 0 |
| 1 | 0 | 0 | 0 | 0 | $\alpha^2$ | $\alpha^2$ |
| 2 | 0 | 0 | 0 | $\alpha^2 = C_5$ | 0 | 0 |
| 2e+1 = 3 | $\alpha^2 = (X_5)$ | $\alpha^5$ | $\alpha^3$ | $\alpha^5 = C_4$ | $\alpha^2$ | $\alpha^5$ |
| 4 | $0 = (X_4)$ | 1 | $\alpha^1$ | $\alpha^4 = C_3$ | $\alpha^6$ | 0 |
| 5 | $\alpha^5 = (X_3)$ | $\alpha^2$ | $\alpha^5$ | $\alpha^2 = C_2$ | $\alpha^6$ | $\alpha$ |
| 6 | $0 = (X_2)$ | 0 | $\alpha^3$ | $\alpha = C_1$ | $\alpha^3$ | 0 |
| m=7 | $\alpha = (X_1)$ | $\alpha^6$ | $\alpha^2$ | $\alpha^6$ | $\alpha^2$ | 0 |
| 8 | $\alpha^3=(P_2)$ | $\alpha^2$ | $\alpha^6$ | $\alpha^2$ | 0 | 0 |
| m+2e=9 | $\alpha^2=(P_1)$ | $\alpha^6$ | $\alpha^2$ | 0 | 0 | 0 |

Bei der Aufstellung der Zustandstabelle ist es der Übersichtlichkeit halber sinnvoll, die nachfolgenden Zustandsgleichungen zu verwenden:

$$Z_{1j} = \alpha Z_{2j-1} + X_j$$

$$Z_{2j} = \alpha^3 Z_{2j-1} + Z_{1j-1}$$

$$Z_{3j} = \alpha Z_{2j-1}$$

$$Z_{4j} = \alpha^3 Z_{2j-1} + Z_{3j-1}$$

$$Y_j = Z_{2j-1} + Z_{4j-1}$$

Figur 3 zeigt die schaltungstechnische Ausführung des kombinierten Divisions-Multiplikationsverfahrens, das die Operationen

$$C(z) = z^{2e}X(z) : G(z)$$

$$Y(z) = C(z)G(z)$$

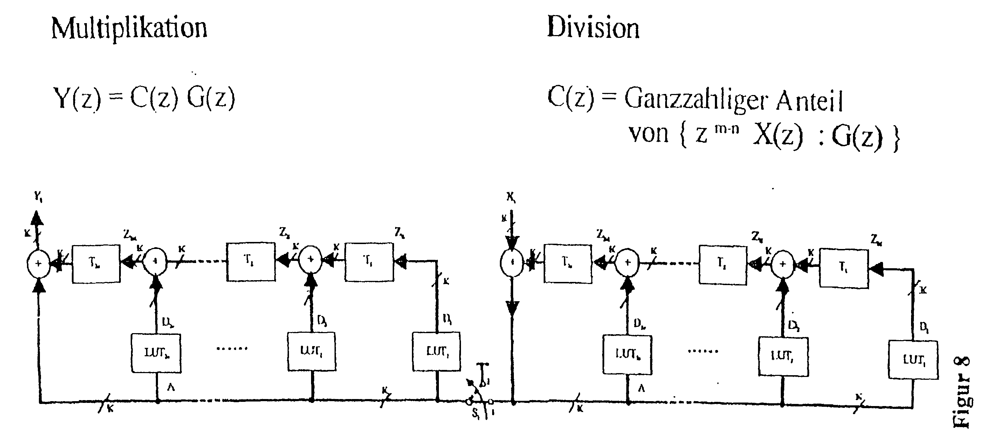

in denselben Speicherelementen durchführt. Der Schalter $S_1$ ist unmittelbar nach dem n-ten Takt von der Stellung 1 in die Stellung 2 zu bringen. Zur Veranschaulichung des Ablaufs sind die Schaltungsteile in Figur 8 getrennt dargestellt.

Zur Ermittlung der 2e Paritätsworte sind bei Verwendung des Generator-polynoms G(z) insgesamt 2e LUT-Tabellen erforderlich. Falls demnach in einem Ausgangsdatenblock [Y] die Anzahl 2e der Paritätsworte [P] größer ist als die Anzahl der Informationsworte, so ist es zur Einsparung von LUT-Tabellen günstiger, die Berechnung der Paritätsworte mit Hilfe eines inversen Polynoms H(z) durchzuführen. Zwischen dem inversen Polynom H(z) und dem Generatorpolynom G(z) besteht der folgende Zusammenhang:

$$H(z) = (z^m + 1) : G(z)$$

Da das dem Ausgangsdatenblock [Y] zugeordnete Ausgangspolynom Y(z) aus dem Informationspolynom X(z) und dem Paritätspolynom P(z) besteht, ergibt sich:

$$Y(z) = Z^{2e}X(z) + P(z).$$

Aus der Bedingung

$$H(z) \cdot Y(z) = C(z) \cdot (z^m + 1),$$

die für jedes Y(z) erfüllt sein muß, resultiert

$$H(z)\, z^{2e}X(z) + H(z)\, P(z) = C(z)\, (z^m + 1).$$

Folglich ist dann

$$P(z) \cdot H(z)\big\|_{\mathrm{mod}\ 2^m+1} = P(z) \cdot H(z) = z^{2e} \cdot X(z) \cdot H(z)\big\|_{\mathrm{mod}\ z^m+1}$$

Die Umstellung nach P(z) liefert:

$$P(z) = \frac{z^{2e} \cdot X(z) \cdot H(z)\,\big|\mathrm{mod}\ z^m+1}{H(z)}$$

Für die Ermittlung der Paritätsworte ergeben sich demnach die folgenden Verfahrensschritte:

(1) Multiplizieren des verschobenen Eingangspolynoms X(z) mit dem inversen Polynom H(z) gemäß den Rechenregeln im $GF(2^K)$;
(2) Dividieren des Ergebnisses aus Schritt (1) durch das Polynom $z^m + 1$ gemäß den Rechenregeln im $GF(2^K)$ und Bestimmen des Rests aus dieser Division;
(3) Dividieren des Rests aus Schritt (2) durch das inverse Polynom H(z) gemäß den Rechenregeln im $GF(2^K)$ und
(4) Gewinnen der Paritätsworte aus den aus Schritt (3) erhaltenen Teilerworten.

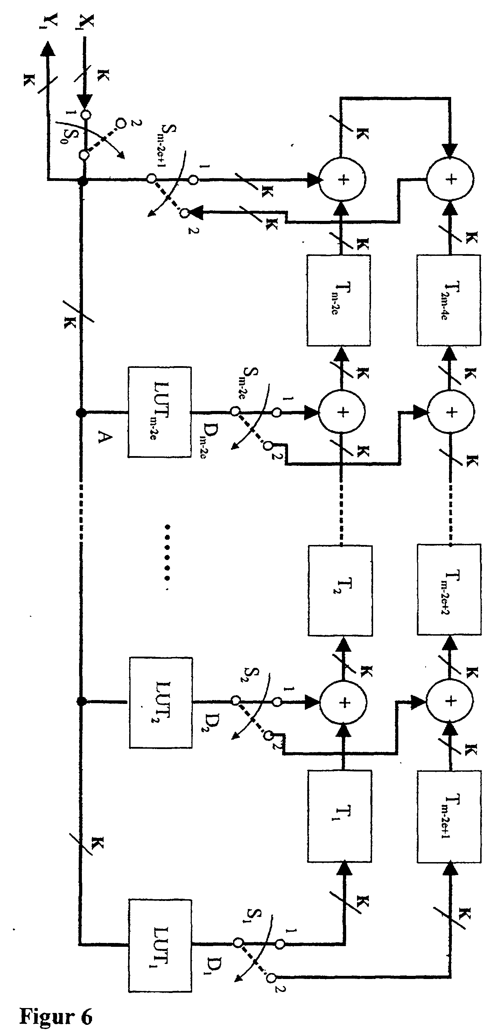

Die schaltungstechnische Ausführung des Verfahrens ist in Figur 6 dargestellt. Die $LUT_1$ stellen die Multiplikation der höchsten Stelle des bei der Polynom-Division bzw. Polynom-Multiplikation entstehenden Zwischenergebnisses mit den jeweiligen Koeffizienten des inversen Polynoms

$$H(z) = z^{m-2e} + h_{2e}z^{m-2e-1} + .... h_2 z + h_1$$

her.

Die LUT$_i$ sind gemäß folgender Gleichung zu programmieren:

$$D_i = A \cdot h_i \qquad i = 1 .... 2e,$$

wobei die Koeffizienten $D_i$, $h_i$, A Elemente aus GF($2^K$) sind und die Multiplikation im GF($2^K$) auszuführen ist. Dieser Vorgang ist einmalig bei der Programmierung durchzuführen. Die Schalter $S_0$ und $S_{m-2e}$ befinden sich zu Beginn der Operation in Stellung 1. Die Multiplikation des Eingangspolynoms X(z) mit dem inversen Polynom H(z) gemäß Schritt (1) geschieht unter Verwendung der Tabellen LUT$_1$ bis LUT$_{m-2e}$ und den K-fachen Ein-Takt-Verzögerungselementen $T_1$ bis $T_{m-2e}$. Die Division des Ergebnisses aus Schritt (1) durch das Polynom $z^m + 1$ und die Restbestimmung erfolgt durch Umschalten der Schalter $S_0$ und $S_{m-2e}$ unmittelbar nach dem m-2e-ten Takt in die Stellung 2. Die Division des Rests aus Schritt (2) durch das inverse Polynom H(z) erfolgt mit Hilfe der K-fachen Ein-Takt-Verzögerungselemente $T_{m-2e+1}$ bis $T_{2m-4e}$. Die den Teilerworten entsprechenden Paritätsworte [P] werden direkt an die Informationsworte [X] angehangen.

Der Vorteil der Schaltung liegt darin, daß nur m-2e LUT-Tabellen verwendet werden, was bei einer Anzahl von 2e Paritätsworten, die groß gegenüber der Anzahl (m-2e) der Informationsworte in einem Block ist, zur Reduzierung des Schaltungsaufwandes führt.

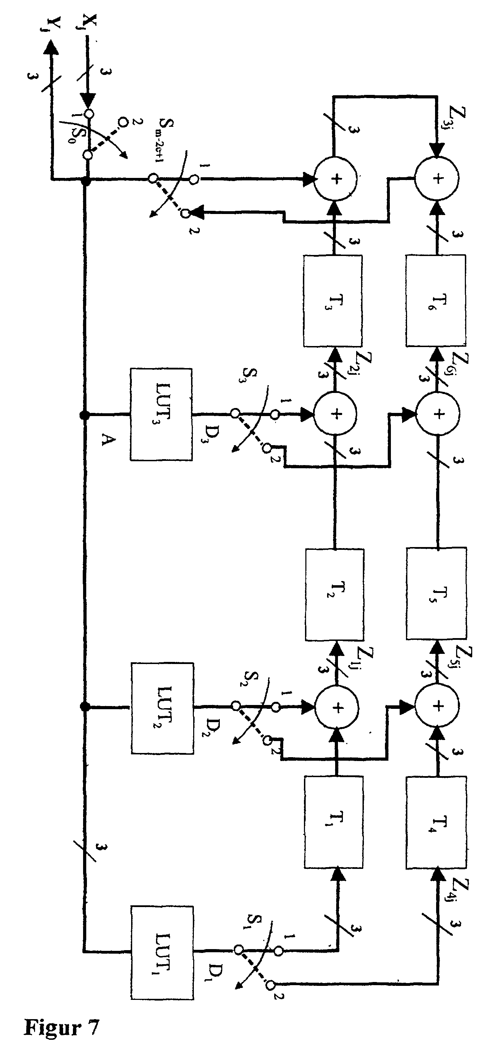

Das Schaltungsbeispiel in Figur 7 zeigt den Aufbau für den Fall, daß 2e=4 Paritätsworte für einen Informationsblock aus K = 3 Bit-Worten ermittelt werden sollen. Der Ausgangsblock hat die Form:

$$[Y] = [X_3 \ X_2 \ X_1 \ P_4 \ P_3 \ P_2 \ P_1]$$

Als Generatorpolynoms wird G(z) = $z^4 + \alpha^2 z^3 + \alpha^5 z^2 + \alpha^5 z + \alpha^6$ zugrunde gelegt. Folglich ergibt sich das inverse Polynom zu H(z) = ($z^m + 1$) G(z) = $z^3 + \alpha^2 z^2 + z + \alpha$. Der Aufbau der LUT-Tabellen ist für dieses Beispiel folgendermaßen durchzuführen:

| Adresse A | Daten $D_1$ |
|---|---|
| 0 | 0 |
| $\alpha$ | $\alpha^2$ |
| $\alpha^2$ | $\alpha^3$ |
| $\alpha^3$ | $\alpha^4$ |
| $\alpha^4$ | $\alpha^5$ |
| $\alpha^5$ | $\alpha^6$ |
| $\alpha^6$ | 1 |
| 1 | $\alpha$ |

| Adresse A | Daten $D_2$ |
|---|---|
| 0 | 0 |
| $\alpha$ | $\alpha$ |
| $\alpha^2$ | $\alpha^2$ |
| $\alpha^3$ | $\alpha^3$ |
| $\alpha^4$ | $\alpha^4$ |
| $\alpha^5$ | $\alpha^5$ |
| $\alpha^6$ | $\alpha^6$ |
| 1 | 1 |

| Adresse A | Daten $D_3$ |
|---|---|
| 0 | 0 |
| $\alpha$ | $\alpha^3$ |
| $\alpha^2$ | $\alpha^4$ |
| $\alpha^3$ | $\alpha^5$ |
| $\alpha^4$ | $\alpha^6$ |
| $\alpha^5$ | 1 |
| $\alpha^6$ | $\alpha$ |
| 1 | $\alpha^2$ |

Zur Aufstellung der LUT-Tabellen sind die $\alpha^i$ als K-Bit-Worte aus GF($2^K$) zu entnehmen. Für den Eingangs-Informationsblock [X] = [$\alpha^5 \ \alpha^2 \ \alpha$] und das inverse Polynom H(z) = $z^3 + \alpha^2 z^2 + z + \alpha$ ergibt sich beispielsweise die folgende taktabhängige Zustandstabelle der Kodierschritte:

| Takt | $Y_j$ | $Z_{6j}$ | $Z_{5j}$ | $Z_{4j}$ | $Z_{3j}$ | $Z_{2j}$ | $Z_{1j}$ | $X_j$ |
|---|---|---|---|---|---|---|---|---|
| 0 | 0 | 0 | 0 | 0 | 0 | 0 | 0 | 0 |
| 1 | $\alpha^5 = (X_3)$ | 0 | 0 | 0 | $\alpha^5 = M_{10}$ | 1 | $\alpha^5$ | $\alpha^2$ |
| 2 | $\alpha^2 = (X_2)$ | 0 | 0 | 0 | $\alpha^6 = M_9$ | 1 | 1 | $\alpha^2$ |
| 3=m-2e | $\alpha = (X_1)$ | 0 | 0 | 0 | $\alpha^3 = M_8$ | $\alpha$ | 1 | $\alpha$ |
| 4 | $\alpha = (P_4)$ | $\alpha^3$ | $\alpha$ | $\alpha^2$ | $\alpha = M_7$ | 1 | $\alpha^2$ | 0 |
| 5 | $\alpha = (P_3)$ | 1 | $\alpha^4$ | $\alpha^2$ | $1 = M_6$ | $\alpha^2$ | 0 | 0 |
| 6 | $\alpha^6 = (P_2)$ | $\alpha^2$ | 1 | 1 | $\alpha^2 = M_5$ | 0 | 0 | 0 |
| 7 = m | $\alpha^2 = (P_1)$ | $\alpha^5$ | $\alpha^6$ | $\alpha^3$ | 0 | 0 | 0 | 0 |

$M_5$ bis $M_{10}$ stellen die Koeffizienten des Ergebnis-Polynoms nach dem Multiplikationsschritt (1) dar. Bei der Aufstellung der Zustandstabelle ist es der Übersichtlichkeit halber sinnvoll, die nachfolgenden Zustandsgleichungen zu verwenden:

$$Z_{1j} = \alpha\, X_{j-1} + X_j \qquad Z_{4j} = \alpha\, Y_j$$

$$Z_{2j} = Z_{1j-1} + \alpha^2\, X_j \qquad Z_{5j} = Z_{4j-1} + Y_j$$

$$Z_{3j} = Z_{2j-1} + X_j \qquad Z_{6j} = Z_{5j-1} + \alpha^2\, Y_j$$

$$Y_j = Z_{6j-1} + Z_{3j}$$

**Patentansprüche**

1. Verfahren zum Erzeugen von fehlergesicherten Datenblöcken durch Erzeugen von 2e Paritätswörtern zu jeweils einem Eingangsdatenblock [X], wobei e = die Anzahl der zu korrigierenden Fehler pro Block darstellt, für einen verkürzten oder unverkürzten, systematischen, zyklischen und $2^K$-wertigen Blockkode, dessen Elemente aus dem $GF(2^K)$ sind und dessen Generatorpolynom G(z) 2e Nullstellen im $GF(2^K)$ erfüllt, **gekennzeichnet durch** folgende Schritte:

   a) Bilden des Generatorpolynoms G(z);
   b) Bilden eines inversen Polynoms H(z) durch Division des Polynoms $z^m + 1$ durch das Generatorpolynom G(z),
   c) Erweitern des Blocks durch Verschiebung des Eingangsblocks $[X] = [X_i\, X_{i-1} ... X_2\, X_1]$ um 2e Wortplätze zur Platzfreigabe für die 2e Paritätsworte $[P_{2e}\, P_{2e-1} ... P_2\, P_1]$, so daß der Ausgangsblock die Form $[Y] = [X_i\, X_{i-1} ... X_2\, X_1\, P_{2e}\, P_{2e-1} ... P_2\, P_1]$ hat
   d) Multiplizieren des verschobenen Eingangspolynoms X(z), das dem Eingangsblock [X] zugeordnet ist, mit dem inversen Polynom H(z) gemäß den Rechenregeln im $GF(2^K)$,
   e) Dividieren des Ergebnisses aus Schritt d) durch das Polynom $z^m + 1$ gemäß den Rechenregeln im $GF(2^K)$ und Bestimmen des Rests aus dieser Division,
   f) Dividieren des Rests aus Schritt e) durch das inverse Polynom H(z) und Ermitteln der Teilerworte $[C_{2e}\, C_{2e-1} ... C_2\, C_1]$ gemäß den Rechenregeln im $GF(2^K)$ und
   g) Gewinnen der Paritätsworte $[P] = [P_{2e}\, P_{2e-1} ... P_2\, P_1]$ aus den aus Schritt f) erhaltenen Teilerworten durch die Identität $[P] = [C_{2e}\, C_{2e-1} ... C_2\, C_1]$.

2. Verfahren nach Anspruch 1, **dadurch gekennzeichnet,** daß das Generatorpolynom gebildet wird durch die im GF $(2^K)$ definierte Multiplikation von insgesamt 2e verschiedenen Ausdrücken, wobei jeder Ausdruck aus der im GF $(2^K)$ definierten Addition des Verschiebeoperators z und einer der möglichen von Null verschiedenen Elemente des $GF(2^K)$ entsteht.

3. Verfahren nach Anspruch 2, **dadurch gekennzeichnet,** daß die Anzahl i der Worte in einem Eingangsblock [X] = [$X_i$ $X_{i-1}$ ... $X_2$ $X_1$] entweder i=24 oder i=28, die Anzahl 2e der Paritätsworte [$P_{2e}$ $P_{2e-1}$ ... $P_2$ $P_1$] 2e=4, das Generatorpolynom $G(z) = (z+\alpha^0)(z+\alpha^1)(z+\alpha^2)(z+\alpha^3)=z^4 + \alpha^{75}z^3 + \alpha^{249}z^2 + \alpha^{78}z + \alpha^6$ und das den Operationen und Elementen zugrundeliegende Galois-Feld $GF(2^K)$ mit K=8 ist, wobei $\alpha^j$ eine Wurzel des Generatorpolynoms ist.

**Claims**

1. A method for generating error-protected data blocks by generating 2e parity words per input data block [X], where e is the number of errors to be corrected per block, for a shortened or unshortened, systematic, cyclic and $2^K$-valued block code whose elements are from $GF(2^K)$ and whose generating polynomial $G(z)$ fulfills 2e zeros in $GF(2^K)$, characterized by the following steps:

   a) forming the generating polynomial $G(z)$;
   b) forming an inverse polynomial $H(z)$ by dividing the polynomial $z^m + 1$ by the generating polynomial $G(z)$,
   c) extending the block by shifting the input block [X] = [$X_i$, $X_{i-1}$, ... $X_2$ $X_1$] by 2e word places to make room for the 2e parity words [$P_{2e}$ $P_{2e-1}$ ... $P_2$ $P_1$] so that the output block has the form [Y] = [$X_i$, $X_{i-1}$, ... $X_2$ $X_1$ $P_{2e}$ $P_{2e-1}$ ... $P_2$ $P_1$];
   d) multiplying the shifted input polynomial $X(z)$ associated with the input block [X] by the inverse polynomial $H(z)$ according to the computing rules in $GF(2^K)$,
   e) dividing the result from step d) by the polynomial $z^m + 1$ according to the computing rules in $GF(2^K)$ and determining the remainder from said division,
   f) dividing the remainder from step e) by the inverse polynomial $H(z)$ and determining the divisor words [$C_{2e}$ $C_{2e-1}$ ... $C_2$ $C_1$] according to the computing rules in $GF(2^K)$, and
   g) obtaining the parity words [P] = [$P_{2e}$ $P_{2e-1}$ ... $P_2$ $P_1$] from the divisor words obtained from step f) by the identity [P] = $C_{2e}$ $C_{2e-1}$ ... $C_2$ $C_1$].

2. The method of claim 1, characterized in that the generating polynomial is formed by multiplying as defined in $GF(2^K)$ altogether 2e different terms, each term arising from adding as defined in $GF(2^K)$ the shift operator z and one of the possible nonzero elements of $GF(2^K)$.

3. The method of claim 2, characterized in that the number i of words in an input block [X] = [$X_i X_{i-1}$ ... $X_2 X_1$] is either i = 24 or i = 28, the number 2e of parity words [$P_{2e}$ $P_{2e-1}$ ... $P_2$ $P_1$] is 2e = 4, the generating polynomial $G(z) = (z+\alpha^0)(z+\alpha^1)(z+\alpha^2)(z+\alpha^3) = z^4 + \alpha^{75}z^3 + \alpha^{249}z^2 + \alpha^{78}z + \alpha^6$, and the Galois field underlying the operations and elements is $GF(2^K)$ with K=8, where $\alpha^j$ is a root of the generating polynomial.

**Revendications**

1. Méthode pour générer des blocs de données protégés contre les erreurs par génération de 2e mots de parité associés respectivement à un bloc de données d'entrée [X], e représentant le nombre des erreurs à corriger par bloc, pour un code de bloc réduit ou non réduit, systématique, cyclique et de valeur $2^K$, dont les éléments sont des éléments de $GF(2^K)$ et dont le polynôme générateur G(z) est basé sur 2e zéros de $GF(2^K)$, caractérisée par les phases suivantes :

   a) Formation du polynôme générateur G(z) ;
   b) Formation d'un polynôme inverse H(z) par division du polynôme $z^m + 1$ par le polynôme générateur G(z) ;
   c) Elargissement du bloc par déplacement du bloc d'entrée [X] = [$X_i$ $X_{i-1}$ ... $X_2$ $X_1$] de 2e emplacements de mots pour libérer de la place pour les 2e mots de parité [$P_{2e}$ $P_{2e-1}$ ... $P_2$ $P_1$], de sorte que le bloc de sortie a la forme [Y] = [$X_i$ $X_{i-2}$ ... $X_2$ $X_1$ $P_{2e}$ $P_{2e-1}$ ... $P_2$ $P_1$];
   d) Multiplication du polynôme d'entrée déplacé X(z), associé au bloc d'entrée [X], par le polynôme inverse H(z) suivant les règles de calcul de $GF(2^K)$;
   e) Division du résultat de la phase d) par le polynôme $z^m + 1$ suivant les règles de calcul de $GF(2^K)$ et détermination du reste de cette division ;
   f) Division du reste de la phase e) par le polynôme inverse H(z) et détermination des mots diviseurs [$C_{2e}$ $C_{2e-1}$ ... $C_2$ $C_1$] suivant les règles de calcul de $GF(2^K)$ et

g) Obtention des mots de parité $[P] = [P_{2e} \, P_{2e-1} \, ... \, P_2 \, P_1]$ à partir des mots diviseurs obtenus dans la phase f) par l'identité $[P] = [C_{2e} \, C_{2e-1} \, ... \, C_2 \, C_1]$.

**2.** Méthode suivant la revendication 1, caractérisée en ce que le polynôme générateur est formé par la multiplication, définie dans $GF(2^K)$, d'au total 2e expressions différentes, chaque expression résultant de l'addition, définie dans $GF(2^K)$, de l'opérateur de déplacement z et de l'un des éléments possibles différents de zéro de $GF(2^K)$.

**3.** Méthode suivant la revendication 2, caractérisée en ce que le nombre i des mots dans un bloc d'entrée $[X] = [X_i \, X_{i-1} \, ... \, X_2 \, X_1]$ est i = 24 ou i = 28, le nombre 2e des mots de parité $[P_{2e} \, P_{2e-1} \, ... \, P_2 \, P_1]$ est 2e = 4, le polynôme générateur $G(z) = (z+\alpha^0)(z+\alpha^1)(z+\alpha^2)(z+\alpha^3) = z^4 + \alpha^{75}z^3 + \alpha^{249}z^2 + \alpha^{78}z + \alpha^6$, et le champ de Galois à la base des opérations et des éléments est $GF(2^K)$ avec K = 8, $\alpha^j$ étant une racine du polynôme générateur.

**Figur 1**

Figur 2

**Figur 3**

Figur 4

Figur 5

Figur 6

**Figur 7**

Figur 8

Multiplikation

$$Y(z) = C(z) \, G(z)$$

Division

$$C(z) = \text{Ganzzahliger Anteil}$$
$$\text{von} \{ z^{m-n} \, X(z) : G(z) \}$$